Europäisches Patentamt

(19) European Patent Office

Office européen des brevets

(11) Publication number: **0 069 580**
**B1**

(12) **EUROPEAN PATENT SPECIFICATION**

(45) Date of publication of patent specification: **06.05.87**

(21) Application number: **82303526.6**

(22) Date of filing: **05.07.82**

(51) Int. Cl.⁴: **H 01 L 21/205**, H 01 L 29/167

(54) Method of producing thin films of silicon.

(30) Priority: **08.07.81 JP 105703/81**
**08.07.81 JP 105704/81**

(43) Date of publication of application:
**12.01.83 Bulletin 83/02**

(45) Publication of the grant of the patent:
**06.05.87 Bulletin 87/19**

(84) Designated Contracting States:
**DE FR GB NL**

(56) References cited:
**DE-A-2 743 141**
**DE-A-2 904 171**

**JAPANESE JOURNAL OF APPLIED PHYSICS,
vol. 19, 1980, Supplement 19-2, Pages 137-141,
Tokyo, JP, Y. KUWANO et al.: "Amorphous si
photovoltaic cells and cell module (integrated
cell module)"**

**JAPANESE JOURNAL OF APPLIED PHYSICS,
vol. 19, no. 6, June 1980, pages L305-L308,
Tokyo, JP, A. MATSUDA et al.: "Electrical and
structural properties of phosphorous-doped
glow-discharge Si:F:H and Si:H films"**

(73) Proprietor: **THE STATE OF JAPAN, as
Represented by the DIRECTOR GENERAL of the
AGENCY of INDUSTRIAL SCIENCE and
TECHNOLOGY
3-1, Kasumigaseki 1-chome Chiyoda-ku
Tokyo 100 (JP)**

(73) Proprietor: **TOA NENRYO KOGYO KABUSHIKI
KAISHA
1-1 Hitotsubashi, 1-Chome Chiyoda-Ku
Tokyo 100 (JP)**

(72) Inventor: **Tanaka, Kazunobu**
**1-4 Sakuramura Umezono 1-chome
Niihari-gun Ibaraki (JP)**
Inventor: **Matsuda, Akihisa**
**1-4 Sakuramura Umezono 1-chome
Niihari-gun Ibaraki (JP)**
Inventor: **Yoshida, Toshihiko**
**1902-5, Oaza Kamekubo Oi-machi
Iruma-gun Saitama-ken (JP)**

(74) Representative: **Harvey, David Gareth et al
Graham Watt & Co. Riverhead
Sevenoaks Kent TN13 2BN (GB)**

EP 0 069 580 B1

**0 069 580**

**Description**

This invention relates to a method of producing thin films of silicon useful in such applications as diodes, solar cells, image pick up tubes and electrographic printers for readers, for example.

One method of making silicon substrates is disclosed in DE—A—2 904 171. By performing several successive deposition and hydrogenation steps, an amorphous silicon substrate is built up, layer by layer, upon a backing substrate. A first layer of silicon is deposited from a plasma atmosphere of silicon halide and hydrogen. This layer is then exposed to a plasma atmosphere of hydrogen alone, to cause free valences (so-called "dangling bonds") in the layer to be satisfied by atomic hydrogen. Another silicon layer is deposited and then hydrogenated, and these steps are repeated until the silicon substrate has whatever thickness is desired. The product of this method, which is alleged to possess a homogeneous distribution of hydrogen throughout its thickness, can thereafter be processed using known production steps e.g. to develop p-n junctions.

To suit their intended uses, thin films of silicon have been employed alone or more generally in the form of p-i-n or p-n junction devices. Those devices are usually made in a process combining two or three film-forming steps, viz., by first forming a p-type thin film of silicon doped, e.g. with boron (B) as an impurity element, in a plasma atmosphere by glow discharge, and then allowing to grow thereon either an undoped i-type thin film of silicon as an active layer and an overlying phosphorus (P) doped n-type thin film of silicon or the latter directly without the intermediate layer. Alternatively in a similar but reverse way, a thin n-type film layer is formed first and then either i- and p-type layers are deposited thereon, or the p-type layer alone is deposited directly on the n-type layer. A disadvantage common to devices made by the conventional film-forming techniques is that, in the course of depositing a layer over a grown layer, the impurity in the underlying, already grown, film tends to be released in the plasma atmosphere and gain entrance into the film being formed thereon. Consequently, as compared with a film deposited on an impurity-free substrate, a film grown on an impurity-containing backing shows decreases in photoelectric and dark electric conductivities. This is particularly true with a junction semiconductor device, consisting of a substrate and p-, i-, and n-type layers deposited thereon in the order mentioned, for fabrication into a solar cell. Ingress of the dopant impurity from the p-type to the i-type film lowers the photoelectric and dark electric conductivities and renders it impossible to provide good junctions. On the other hand, a device formed in the reverse order (i.e., comprising the substrate and n-, i-, and p-type layers thereon) cannot obtain adequate open voltage because the partial transfer of the impurity from the n-type to the i-type film causes a shift of the Fermi level position. Altogether, the aforesaid drawbacks lead to a decline in the photoenergy conversion efficiency, and those junctions in fact affect adversely the performance of the solar cells and other end products incorporating them.

The present inventors have now found that if a p- or n-type thin film of silicon doped with an impurity element is placed under a plasma discharge of at least one gas chosen from among the elements fluorine, chlorine, bromine, iodine, and hydrogen, the p- or n-type film will show a decrease in its impurity concentration in the portion from the surface to a depth of 5000 Å, (500 nm), and the vacant bonds that have resulted from the removal of the impurity from the p- or n-type silicon film become attached to the plasma discharge gas, thus forming a barrier layer which avoids further release of the impurity from the silicon film into the plasma atmosphere.

It has also been found that the degree of impurity loss from the thin film of silicon and the depth of the film portion in which the impurity depletion takes place can be varied over broad ranges by adjusting the pressure during the plasma discharge inside the vacuum vessel, the discharge time, and the power density for discharge.

The pressure during the discharge, one of the essential parameters for practicing the method of this invention, is controlled desirably within a range from $1.5 \times 10^{-2}$ to 3 torrs (0.02 to 4 mbar). If the discharge pressure is less than $1.5 \times 10^{-2}$ torr (0.02 m bar), the flow inside the vacuum vessel will become a diffusion with an increasing possibility of the once released impurity finding entrance back into the silicon film substrate. Thus, in order to keep the flow inside the vessel viscous, the pressure should be not less than $1.5 \times 10^{-2}$ torr (0.02 m bar). The upper limit of 3 torrs (4 m bar) is put primarily by reason of apparatus factors, so as to prevent any discharge between electrodes and earth shields. The discharge power density varies depending on the properties of the plasma gas to be employed but a value between 0.5 and 50 $W/cm^2$ is suitable. Under these conditions the discharge time is variable as desired within a range of one second to five hours. With regard to the relation between the discharge power density and the discharge time, it may generally be said that the discharge power density influences the depth of the film portion in which the impurity element originally added as a dopant decreases, while the discharge time influences the decrease in the originally added impurity concentration.

The flow rate of the plasma element gas into the vacuum vessel to bring a plasma state must be so fixed as to maintain the plasma state stable. Experiments have indicated that a flow rate ranging from 0.5 to 100 SCCM gives good result.

According to the present invention, there is provided a method of preparing thin films of silicon, characterised in that a thin film of silicon doped with a p-type or n-type impurity element is placed under a plasma discharge of at least one gas selected from fluorine, chlorine, bromine, iodine and hydrogen, the pressure during plasma discharge, the discharge time and the power density are adjusted to decrease the

2

concentration of the impurity element from the surface of the silicon film up to a predetermined depth and allow atoms of the plasma discharge gas to become attached to dangling bonds resulting from the removal of impurity atoms from the film, thereby forming a barrier against further release of impurity atoms from the film into the plasma atmosphere.

The said depth can be down to 5000 Å (500 nm) from the surface and the bonds broken as a result of the impurity removal attach themselves to atoms of the plasma discharge gas.

Thus, the p-type or n-type thin film of silicon produced in accordance with the invention, when subjected to a low-power plasma discharge in the next process stage for deposition thereon, e.g., of an i-type film layer, will not release its impurity into the latter layer.

When a film is caused to grow in a plasma atmosphere on an n-type or p-type thin film substrate formed in a conventional way, the plasma-grown film will contain more than $10^{16}$ atoms/cm$^3$ of the impurity from the substrate film. In contrast with that, when a film is grown in a like manner on a substrate formed by the method of the invention, the release of the impurity from the substrate film to the overlying film can be controlled within $10^{16}$ atoms/cm$^3$.

In practising this invention as described in detail by way of example hereafter, a p-type or n-type thin film of silicon can be obtained which, upon exposure to a given plasma atmosphere, will release little, if any impurity with which it is doped. The method of producing thin films of silicon according to this invention is useful in fabricating inter alia solar cells, image pick up tubes, electrographic printers for readers, and diodes, with good photoelectric and dark electric conductivities.

The invention will become more apparent when reference is made to the following description and accompanying drawings, which are given by way of example only. In the drawings,

Fig. 1 is a schematic representation of an apparatus for practicing the method of producing a thin film of silicon in accordance with the invention;

Fig. 2 is a graph showing the electric conductivity of a thin film of silicon made by the method of the invention as a function of plasma discharge time;

Fig. 3 is a graph in which the results of SIMS measurement of the thin silicon film produced by the present method are plotted;

Fig. 4 is a schematic representation of another apparatus for practicing the method of producing a thin film of silicon in accordance with the invention; and

Fig. 5 is a graph in which the results of SIMS measurement of the thin silicon film produced by the present method are plotted.

In the practice of the present method may be used a p-type or n-type thin film of silicon, such as a single-crystal semiconductor of silicon or an amorphous silicon semiconductor. This can be made by deposition from a mixture of silane ($SiH_4$) and a dopant gas as a gaseous starting material onto a given substrate in a plasma atmosphere. Also employable, desirably as a further alternative, is a thin silicon film prepared as disclosed in our copending Japanese Patent Application No. 143010/1980. Thus, a thin film of silicon is formed from a gaseous starting material produced by mixing a dopant gas with either silane, $SiH_4$, or a halogenated silane $SiH_{0-3}X_{4-1}$ (where X represents a halogen element) or a gaseous mixture of two or more such silanes, the gaseous mixture is diluted with helium, neon, argon, or other rare gas, or hydrogen, or the like in a ratio greater than about 1:1 so as to control the film-forming rate adequately and produce a crystalline-noncrystalline mixture layer, and electric power is applied with a plasma discharge power density of not less than about 0.2 W/cm$^2$.

The method of preparing thin films of silicon in accordance with the invention will be described now in connection with preferred examples.

## Example 1

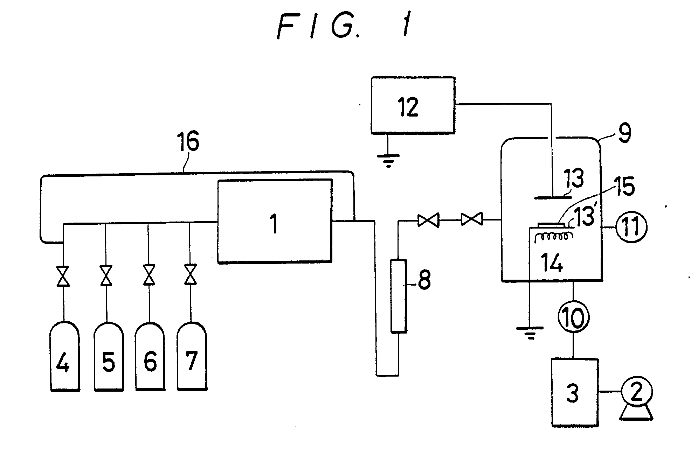

Referring to Fig. 1, the whole apparatus system is shown and includes a mixing vessel 1 which is kept evacuated to about $10^{-6}$ torr ($1.3 \times 10^{-6}$ m bar) by means of a rotary oil pump 2 and an oil diffusion pump 3. Gases from a silane cylinder 4, a hydrogen cylinder 5, and either a dopant gas (diborane or phosphine) cylinder 6 or 7 are introduced at predetermined rates into the mixing vessel 1, where they are mixed. The gaseous mixture is transferred through a flowmeter 8 into a vacuum vessel 9 at a constant flow rate. Through manipulation of a main valve 10 the vacuum in the vessel 9, while being monitored with a vacuum indicator 11, is maintained at a predetermined level. A RF power supply 12 applies a RF voltage between electrodes 13 and 13' to cause a glow discharge. A substrate 15 is placed on a base preheated by a heater 14 and is heated to a predetermined temperature so as to be ready for the deposition thereon of a thin, doped film of silicon.

In this example the starting gaseous material was a 1:1 mixture of $SiH_4$ and $H_2$, with the addition of 2% (by volume) of diborane ($B_2H_6$) on the basis of the $SiH_4$ volume. The conditions under which a p-type thin film of silicon was formed prior to a treatment in a hydrogen plasma atmosphere were as follows: The plasma-discharge power density was 0.1 W/cm$^2$, material gas flow rate was 15 SCCM, substrate temperature was 300°C, and film-forming pressure was $5 \times 10^{-2}$ torr (0.07 m bar).

After the thin film of silicon has been formed in the foregoing way, the whole system including the vessel 9 was evacuated to about $10^{-6}$ torr ($1.3 \times 10^{-6}$ m bar) by the pumps 2, 3. Next, hydrogen gas from the hydrogen cylinder 5 was directly supplied through line 16 to the flowmeter 8 and thence into the vacuum vessel 9 at a constant flow rate.

3

The main valve 10 was operated and the vacuum in the vessel 9 was adjusted to 1 torr (1.3 m bar) under observation through the vacuum indicator 11. Then, a high-frequency voltage of 13.56 MHz was applied between the electrodes 13 and 13' by the RF power supply 12 to effect a hydrogen-plasma glow discharge.

TABLE 1

| | Specimen No. | | | | |
|---|---|---|---|---|---|
| | 1 | 2 | 3 | 4 | 5 |
| Power density (W/cm$^2$) | — | 0.8 | 0.8 | 0.8 | 0.8 |
| Substrate temp. (°C) | — | 300 | 300 | 300 | 300 |
| Discharge pressure (Torr) | — | 1 | 1 | 1 | 1 |
| Hydrogen flow rate (SCCM) | — | 10 | 10 | 10 | 10 |
| Discharge time (min) | — | 3 | 7 | 30 | 60 |
| Electric conductivity ($\Omega^{-1}$ cm$^{-4}$) | $1.10\times10^{-4}$ | $3.69\times10^{-6}$ | $5.73\times10^{-7}$ | $4.55\times10^{-7}$ | $1.06\times10^{-6}$ |
| Optical band gap (a.u.) | 1.00 | 1.01 | 1.04 | 1.03 | 1.09 |
| Substrate conductivity type | | | Boron-doped p-type | | |

This gave a p-type, amorphous thin film of silicon whose surface portion had been depleted of the impurity, with the resulting dangling bonds replaced by hydrogen. The hydrogen-plasma discharge condition, or discharge time, was varied and four different p-type, amorphous thin films of silicon were made. The results are shown in Table 1. Specimen No. 1 represents a p-type thin film of silicon made conventionally without subjection to a hydrogen plasma discharge. Specimen Nos. 2 to 5 are the p-type thin films of silicon made in conformity with the present invention, i.e., by a procedure such that the flow inside the apparatus was placed in a viscous flow region by adjusting the hydrogen gas flow rate and the pressure during the hydrogen plasma discharge so that the boron once released from the walls of the vacuum vessel and the thin film of silicon may not re-enter the silicon film.

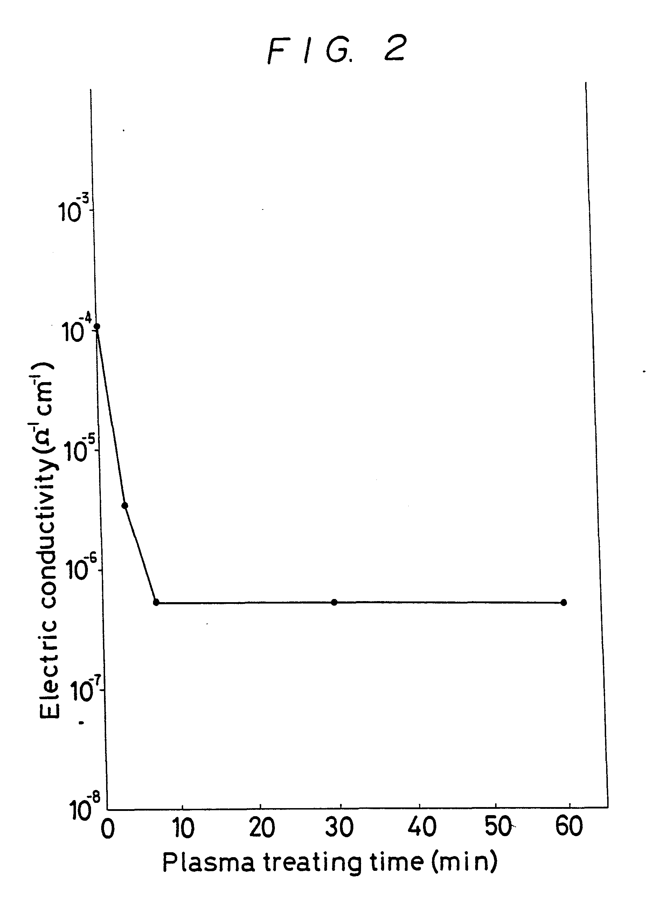

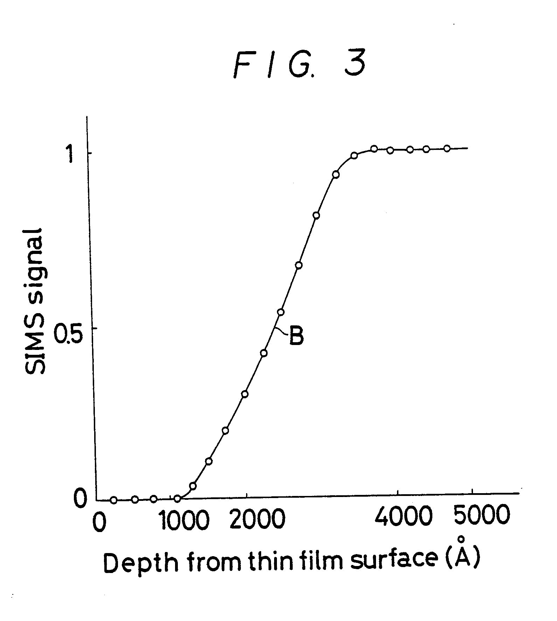

Fig. 2 is a graphic representation of the electric conductivity of the thin silicon film made in accordance with the invention as a function of hydrogen-plasma treating time. The graph indicates that the method of the invention reduced the boron atom concentration in the surface portion of the silicon film. Also, it was confirmed by a SIMS measurement that the p-type thin film according to the invention was completely free from boron atoms in the surface region extending inwardly to the depth of 1000 Å (100 nm). Refer to Fig. 3.

Example 2

An n-type thin film of silicon was formed by the same procedure as described in Example 1 except that phosphine ($PH_3$) was used instead for introducing the dopant, and the thin film so obtained was treated with a hydrogen plasma in the same way as in Example 1.

By a SIMS measurement complete removal of phosphorus atoms from a 500 Å-deep (50 nm) portion of the n-type thin film according to the invention was confirmed.

From the foregoing description it will be understood by those skilled in the art that the p-type or n-type thin film of silicon produced by the method of the invention permits the manufacture of a pn or pin junction device by a subsequent step of ordinary film-forming technique. A pin-junction semiconductor device, made by depositing, on a p-type (or n-type) film formed in accordance with the invention, an i-type film and then an n-type (or p-type) film, provides a better p-i (or n-i) junction than existing devices of the same character. Similarly, a p-n junction semiconductor device, obtained by depositing an n-type (or p-type) film on a p-type (or n-type) film prepared according to the invention, gives a better p-n junction than ordinary ones. It is also possible to apply this invention to a p-type film substrate and thoroughly remove the impurity from the surface portion of the substrate film to convert the substrate to a p-i-type thin film of silicon. In that case an n-type film may be deposited on the p-i-type film to yield a p-i-n junction semiconductor device.

As a result of further researches and experiments, the present inventors have now found that, if a p- or n-type thin film substrate of silicon doped with an impurity element is placed under a plasma discharge of a gaseous mixture of at least one element selected from the group consisting of fluorine, chlorine, and hydrogen, and a gas of an impurity dissimilar to the impurity in the silicon film substrate, the silicon film substrate will show a decrease in its impurity concentration in the surface portion down to a depth of 5000 Å (500 nm) while, at the same time, the substrate is doped to a desired depth with the dissimilar impurity in the gaseous mixture.

It has also been found that the degree of impurity depletion in the thin film silicon substrate, the depth of the film in which the impurity decrease takes place, and the concentration and depth of doping with the new, dissimilar impurity in the substrate can be varied over broad ranges by adjusting (1) the composition of the gaseous mixture to be placed under the plasma discharge conditions, (2) the pressure during, and the duration of, the plasma discharge in the vacuum vessel, and (3) the plasma-discharge power density.

The present invention is predicated upon the aforedescribed novel findings. Briefly, the method of preparing thin films of silicon in accordance with the invention is distinguished in that a thin film substrate of silicon doped with an impurity (A) is placed in a plasma discharge state of a gaseous mixture consisting of the gas of an element selected from the group consisting of fluorine, chlorine, and hydrogen, and a gas containing an impurity (B) dissimilar to the impurity (A) in the silicon film substrate, so that the concentration of the impurity (A) is decreased in a superficial portion of the silicon substrate of a predetermined thickness as the substrate is concurrently doped to a desired thickness with the impurity (B).

Bonds that have broken upon the removal of the impurity (A) presumably combine with fluorine or hydrogen atoms.

By way of example, it is assumed that a p-n junction device is made in accordance with the present invention by doping a p-type thin film of silicon containing boron atoms as impurity with phosphorus atoms diffused from one side. To this end, the p-type thin film substrate of silicon is exposed to a plasma discharge of a gaseous mixture which consists of either phosphine, $PH_3$, diluted with hydrogen or phosphorus pentafluoride diluted with fluorine. The result is that the boron atom concentration in the p-type silicon film substrate is reduced in the exposed surface portion down to a desired depth, and simultaneously the same substrate is doped to a given depth with phosphorus atoms extracted from the gaseous mixture. In this way a p-n junction device is made without the need of any film-forming process. Another example will be cited in which a p-n junction device is made by application of the method of the invention, by boron-atom doping an n-type thin-film substrate of amorphous silicon containing phosphorus atoms as impurity. In this case, the n-type silicon film substrate is exposed to a plasma discharge of a gaseous mixture which consists of diborane, $B_2H_6$, diluted with hydrogen or of boron trifluoride diluted with fluorine. This operation reduces the phosphorus atom concentration in the n-type silicon film substrate in the exposed surface down to a desired depth while the same film is doped to a given depth with boron atoms extracted from the gasous mixture. A p-n junction device is made in this way without any film-forming process.

In either case the depth of impurity reduction and the depth of doping with the other impurity can be controlled by changing the composition, or mixing ratio, of the gaseous mixture. By so doing varied p-n junction devices and also p-i-n junction devices having various desired properties can be obtained. To be more specific, the composition of the gaseous mixture is a parameter as important as the pressure and duration of the discharge and the power density in practicing the method of the invention. The gas composition is such that, when the ratio of impurity (B) gas to fluorine or hydrogen gas is low, the depth of doping with the new impurity (B) will be less than the depth down to which the concentration of the originally added impurity (A) is decreased in the silicon film substrate through the agency of fluorine or hydrogen. Therefore, the resulting device is a p-i-n junction. On the other hand, when the said gas ratio is higher, the depth of the substrate surface portion in which the concentration of the impurity (A) is decreased by fluorine or hydrogen and the depth of doping with the new impurity (B) are substantially the same. Hence, the product is a p-n junction device. In the practice of this invention it has been found that a desirable gaseous mixture composition is $B_2H_6$, $BF_3/H_2$ or $PH_3$, $PF_5/H_2$ in a range of $10^{-5}$ to $10^{-1}$. The rate of flow of the gaseous mixture into the vacuum vessel must be so chosen as to keep the plasma condition stable. Experiments have shown that a flow rate between 0.5 and 100 SCCM gives good results.

The pressure during the discharge, one of essential parameters for practicing the method of the invention, is controlled, preferably within a range from $1.5 \times 10^{-2}$ to 3 torrs (0.02 to 4 m bars). If the discharge pressure is less than $1.5 \times 10^{-2}$ torr, (0.02 m bar), the flow inside the vacuum vessel will become a diffusion flow with an increasing possibility of the released impurity finding its way back into the silicon substrate. Thus, in order to keep the flow inside the vessel viscous, the pressure should be not less than $1.5 \times 10^{-2}$ torr (0.02 m bar). The upper limit of 3 torrs (4 m bars) is set primarily by reason of apparatus factors, so as to prevent discharge between the electrodes and earth shields. The discharge power density varies depending on the properties of the plasma gas to be employed, but a value between 0.5 and 50 $W/cm^2$ is suitable. Under these conditions the discharge time can be varied as desired within a range from one second to five hours. With regard to the relation between the discharge power density and the discharge time, it may generally be said that the discharge power density influences both the depth of the film portion in which the original impurity element added as the dopant decreases and also the depth of doping with the newly added impurity. Discharge time influences the decrease in the original impurity concentration and the degree of doping with the new impurity.

As will be clear from the foregoing, this invention provides a method of producing thin films of silicon, whereby a p-n or p-i-n type thin film can be made with fewer film-forming steps than in prior art methods. The resulting films are useful, for example, in fabricating solar cells, image pick up tubes, electrographic printers for readers, and diodes, etc., having good photoelectric and dark electric conductivities.

In performing the present method, the starting thin film substrate to be subjected to the process according to the invention may be p-type or n-type. The film can be a single-crystal semiconductor or an amorphous silicon semiconductor made by depositing a mixture of silane ($SiH_4$) and a dopant gas as a gaseous starting material on a given substrate in a plasma atmosphere. Also employable desirably as a

5

further alternative is the thin silicon film comprising a silicon amorphous layer in which microcrystalline particles are mixed and dispersed, as disclosed in our copending Japanese Patent Application No. 143010/1980, and summarised in its essentials hereinbefore.

The method of producing thin films of silicon in accordance with the invention is described below with reference to two further Examples.

Example 3

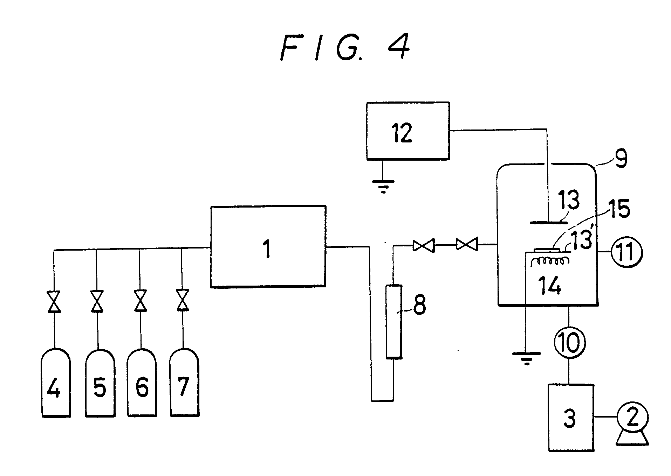

Referring to Fig. 4, the apparatus again includes a mixing vessel 1 kept evacuated to about $10^{-6}$ torr $(1.3 \times 10^{-6}$ m bar) by means of a rotary oil pump 2 and an oil diffusion pump 3, and gases from a fluorine cylinder 4 or hydrogen cylinder 5, and either a dopant gas (sibolane or phosphine) cylinder 6 or 7 are introduced at predetermined rates into the mixing vessel 1, where they are mixed. The gaseous mixture is transferred through a flowmeter 8 into a vacuum vessel 9 at a constant flow rate. Through manipulation of a main valve 10 the vacuum in the vessel 9, while being monitored with a vacuum indicator 11, is maintained at a predetermined level. The flow condition in the vacuum vessel is adjusted to be in a viscous flow region so as to prevent the impurity extracted from the substrate film gaining entrance back into the film. This end is achieved primarily by maintaining a pressure of not lower than $1.5 \times 10^{-2}$ torr (0.02 m bar) in the vacuum vessel. A RF power supply or DC source 12 is used to apply a high-frequency voltage between electrodes 13 and 13' to produce a glow discharge. As a substrate 15, either an n-type or p-type thin film of silicon is employed. The substrate film desirably ranges in thickness from 0.1 to 1 μm, while a 0.7 μm-thick film was used in this example. The substrate 15 was placed on a base plate preheated by a heater 14, and is heated to a predetermined temperature. By the procedure so far described, the thin film substrate of silicon is converted to a p-n or p-i-n junction device.

Table 2 summarizes this example of the method according to the invention. The film-forming conditions for the p-type thin film substrate of silicon used were as follows. A 1:1 gaseous mixture of $SiH_4$ and $H_2$ was used as the starting gaseous material, with the addition of 2% (by volume) of diborane, $B_2H_6$, as a dopant on the basis of the $SiH_4$ volume the plasma-discharge power density was 0.1 $W/cm^2$, film-forming pressure was $5 \times 10^{-2}$ torr (0.07 m bar), material gas flow rate was 15 SCCM, and the film-forming time was 60 minutes. The p-type silicon substrate was made on an ITO transparent electrode under the film-forming conditions described in Example 1.

TABLE 2

| | Spec. No. 1 | Spec. No. 2 |
|---|---|---|
| Carrier gas | $H_2$ | $H_2$ |
| Doping gas composition (by volume) | $PH_3/H_2=2\%$ | $PH_3/H_2=2\%$ |
| Gas flow rate (SCCM) | 5 | 5 |
| Power density (W/cm²) | 1.3 | 0.8 |
| Substrate temperature (°C) | 300 | 300 |
| Discharge pressure (torr) | $3 \times 10^{-1}$ | $3 \times 10^{-1}$ |
| Discharge time (min) | 60 | 30 |
| Substrate conductivity type | p | p |

The devices of Specimen Nos. 1 and 2 in Table 2 were found to be rectifying because of their V-i characteristics, and this indicated that actual p-n junction devices had been made.

Specimen No. 2 was subjected to an EMX measurement and was tested for gas release on heating. The results showed that the p-type silicon film had contained 4 atom.% of phosphorus atoms as an evidence of doping with phosphorus atoms.

Example 4

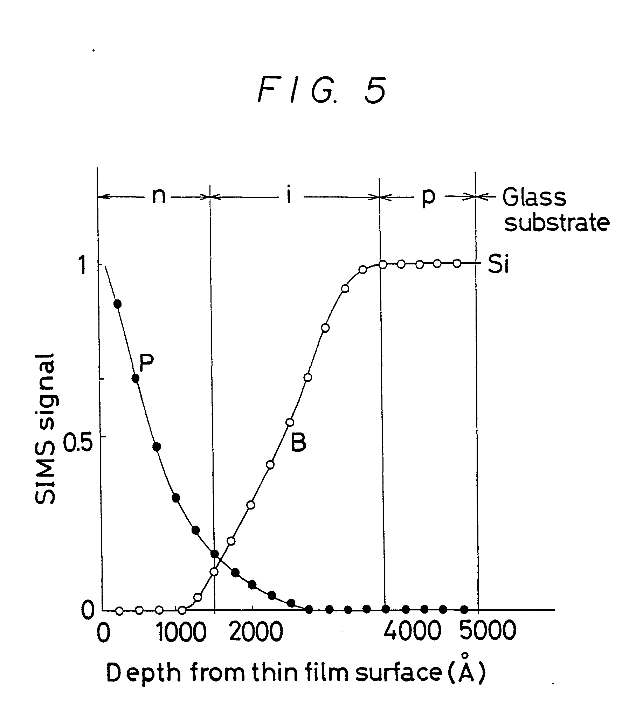

In the same way as described in Example 3, a pin junction device was made by treating a boron-doped, p-type thin film substrate of amorphous silicon (5000 Å—500 nm in thickness) in a plasma atmosphere of a gaseous mixture of $PH_3$ gas and hydrogen gas. From its V-i characteristic the product was confirmed to be a p-i-n junction device. Fig. 5 gives the results of SIMS measurement. It will be understood from this graph that the boron concentration in the substrate film decreases in the portion from the surface to a depth of 3500 Å (350 nm) and that the film is newly doped with phosphorus extracted from the gaseous mixture.

As has been described hereinabove, the method according to the invention renders it possible to reduce the impurity concentration in a p- or n-type thin film substrate of silicon from the surface to a given depth and simultaneously dope the silicon film with a new impurity. Consequently, the method of the

6

invention permits the manufacture of p-n or p-i-n junction devices with fewer film-forming steps than in ordinary methods. The invention thus offers advantages of simplified processing and increased productivity of silicon semiconductors, with the possibility of producing diodes, solar cells, etc. of improved performance.

In the foregoing description and drawings, the abbreviation "SIMS" stands for Secondary Ion Mass Spectroscopy.

"EMX" referred to hereinbefore is a trade designation for a measuring instrument produced by the Japanese company Shimadzu Seisakusho, Ltd., by means of which electron probe micro-analysis can be performed.

## Claims

1. A method of preparing thin films of silicon, characterised in that a thin film of silicon doped with a p-type or n-type impurity element is placed under a plasma discharge of at least one gas selected from fluorine, chlorine, bromine, iodine and hydrogen, the pressure during plasma discharge, the discharge time and the power density are adjusted to decrease the concentration of the impurity element from the surface of the silicon film up to a predetermined depth and allow atoms of the plasma discharge gas to become attached to dangling bonds resulting from the removal of impurity atoms from the film, thereby forming a barrier against further release of impurity atoms from the film into the plasma atmosphere.

2. A method according to claim 1, characterised in that the pressure during the plasma discharge is controlled so as to maintain flow in the vessel holding said plasma atmosphere in a viscous flow region.

3. A method according to claim 2, characterised in that the pressure during the plasma discharge is in the range from $1.5 \times 10^{-2}$ to 3 torrs (0.02 to 4 m bars).

4. A method according to claim 1, 2 or 3, characterised in that the depth of the surface portion in which the impurity concentration is decreased is controlled by varying the electric power density within a range from 0.5 to 50 W/cm².

5. A method according to claim 4, characterised in that the said impurity concentration is decreased from the surface down to a depth of 5000 Å (500 nm).

6. A method according to any of claims 1 to 5, characterised in that the thin film is a single-crystal silicon semiconductor of silicon or an amorphous silicon semiconductor.

7. A method according to any of claims 1 to 5, characterised in that the thin film of silicon is a silicon semiconductor of an amorphous layer in which microcrystalline particles are mixed and dispersed.

8. A method according to claim 1 or any of claims 2 to 7, characterised in that after reducing the concentration of said impurity element and accordingly replacing it by said plasma element(s), an n-type or p-type thin film of silicon is deposited on said thin film.

9. A method according to claim 1 or any of claims 2 to 7, characterised in that after reducing the concentration of said impurity element and accordingly replacing it by said plasma element(s) an i-type thin film of silicon and further an n-type or p-type thin film of the same material are deposited on said plasma-treated film.

10. A method according to claim 1 or any of claims 2 to 7, characterised by adding to the plasma discharge gas a gas containing a second impurity element of opposite conductivity type to the impurity element originally in the film, so that as the concentration of the original impurity element is decreased, concurrently the film is doped to a desired depth with the second impurity element.

11. A method according to claim 10, characterised in that the depth in which the concentration of the original impurity element is decreased and the depth of doping with the second impurity element are controlled by changing the ratio of the second impurity element gas to the said selected gas within a range of $10^{-5}$ to $10^{-1}$ and power density is controlled within a range from 0.5 to 50 W/cm².

## Patentansprüche

1. Verfahren zur Herstellung von dünnen Schichten aus Silizium, dadurch gekennzeichnet, daß eine dünne Schicht von mit einem P-Typ- oder N-Typ-Fremdstoffelement dotiertem Silizium einer Plasmaentladung von zumindest einem Gas aus der Gruppe Fluor, Chlor, Brom, Jod und Wasserstoff ausgesetzt wird, der Druck während der Plasmaentladung, die Entladungszeit und die Leistungsdichte so eingestellt werden, daß die Konzentration des Fremdstoffelements von der Oberfläche der Siliziumschicht bis zu einer vorbestimmten Tiefe verringert wird und sich Atome des Plasmaentladungsgases an aus der Wegnahme von Fremstoffatomen aus der Schicht resultierenden losen Bindungen anfügen können, wodurch eine Sperre gegen ein weiteres Freisetzen von Fremdstoffatomen aus der Schicht in die Plasmaatmosphäre gebildet wird.

2. Verfahren nach Anspruch 1, dadurch gekennzeichnet, daß der Druck während der Plasmaentladung in der Weise kontrolliert wird, daß die Strömung im die Plasmaatmosphäre enthaltenden Gefäß im viskosen Strömungsbereich gehalten wird.

3. Verfahren nach Anspruch 2, dadurch gekennzeichnet, daß der Druck während der Plasmaentladung im Bereich von $1,5 \times 10^{-2}$ bis 3 Torr (0,02 bis 4 m bar) liegt.

4. Verfahren nach Anspruch 1, 2 oder 3, dadurch gekennzeichnet, daß die Tiefe des Oberflächenbereichs, in dem die Fremdstoffkonzentration verringert wird, durch Veränderung der elektrischen Leistungsdichte innerhalb eines Bereiches von 0,5 bis 50 W/cm² kontrolliert wird.

5. Verfahren nach Anspruch 4, dadurch gekennzeichnet, daß die Fremdstoffkonzentration von der Oberfläche bis zu einer Tiefe von 5000 Å (500 nm) verringert wird.

6. Verfahren nach einem der Ansprüche 1 bis 5, dadurch gekennzeichnet, daß die dünne Schicht einen Einfachkristall-Silizium-Halbleiter aus Silizium oder einen amorphen Silizium-Halbleiter bildet.

7. Verfahren nach einem der Ansprüche 1 bis 5, dadurch gekennzeichnet, daß die dünne Siliziumschicht einen Silizium-Halbleiter einer amorphen Schicht bildet, in der mikrokristalline Partikel gemischt und verteilt sind.

8. Verfahren nach Anspruch 1 oder einem der Ansprüche 2 bis 7, dadurch gekennzeichnet, daß nach dem Verringern der Konzentration des Fremdstoffelements und dessen entsprechendem Ersetzen durch das Plasmaelement bzw. die Plasmaelemente eine dünne N-Typ- oder P-Typ-Siliziumschicht auf der genannten dünnen Schicht abgelagert wird.

9. Verfahren nach Anspruch 1 oder einem der Ansprüche 2 bis 7, dadurch gekennzeichnet, daß nach dem Verringern der Konzentration des Fremdstoffelements und dessen entsprechendem Ersetzen durch das Plasmaelement bzw. die Plasmaelemente eine dünne I-Typ-Siliziumschicht und des weiteren eine dünne N-Typ- oder P-Typ-Schicht des gleichen Materials auf der plasmabehandelten Schicht abgelagert werden.

10. Verfahren nach Anspruch 1 oder einem der Ansprüche 2 bis 7, dadurch gekennzeichnet, daß dem Plasmaentladungsgas ein Gas zugesetzt wird, das ein zweites Fremdstoffelement eines Leitfähigkeitstyps enthält, der dem des ursprünglich in der Schicht vorhandenen Fremdstoffelements entgegengesetzt ist, so daß bei der Verringerung der Konzentration des ursprünglichen Fremdstoffelements gleichzeitig die Schicht auf eine gewünschte Tiefe mit dem zweiten Fremdstoffelement dotiert wird.

11. Verfahren nach Anspruch 10, dadurch gekennzeichnet, daß die Tiefe, in der die Konzentration des ursprünglichen Fremdstoffelements verringert wird, und die Tiefe der Dotierung mit dem zweiten Fremdstoffelement durch Ändern des Verhältnisses des zweiten Fremdstoffelementgases zu dem ausgewählten Gas innerhalb eines Bereiches von $10^{-5}$ bis $10^{-1}$ kontrolliert werden und die Leistungsdichte innerhalb eines Bereiches von 0,5 bis 50 W/cm² kontrolliert wird.

## Revendications

Procédé de fabrication de films minces de silicium caractérisé en ce qu'on soumet un film mince du silicium, dopé avec un élément d'impureté du type (p) ou du type (n), à une décharge dans un plasma d'au moins un gaz choisi parmi le fluor, le chlore, le brome, l'iode et l'hydrogène, la pression pendant la décharge dans le plasma, la durée de la décharge et la densité de puissance sont ajustées de manière à réduire la concentration de l'élément d'impureté à partir de la surface du film mince de silicium jusqu'à une profondeur prédéterminée et à permettre à des atomes du gaz employé pour la décharge dans le plasma de venir se fixer à des valences libres ou "liaisons ballantes" résultant de l'enlèvement d'atomes d'impureté à partir du film, en formant ainsi une barrière à l'encontre de toute extractionadditionnelle d'atomes d'impureté à partir du film vers et dans l'atmosphère du plasma.

2. Procédé suivant la revendication 1 caractérisé en ce que la pression pendant la décharge dans le plasma est commandée de manière à maintenir l'écoulement, dans le récipient contenant l'atmosphère du plasma, dans une zone à écoulement visqueux.

3. Procédé suivant la revendication 2 caractérisé en ce que la pression pendant la décharge dans le plasma est comprise dans la gamme allant de 0,02 à 4 millibars.

4. Procédé suivant l'une quelconque des revendications 1, 2 ou 3 caractérisé en ce que la profondeur de la portion superficielle dans laquelle la concentration de l'impureté est diminuée, est commandée en faisant varier la densité de puissance électrique dans la gamme allant de 0,5 à 50 W/cm².

5. Procédé suivant la revendication 4 caractérisé en ce que la concentration en impureté va en diminuant à partir de la surface jusqu'à une profondeur de 5000 Å (500 nm).

6. Procédé suivant l'une quelconque des revendications 1 à 5 caractérisé en ce que le film mince de silicium est un semi-conducteur en silicium monocristallin ou un semi-conducteur en silicium amorphe.

7. Procédé suivant l'une quelconque des revendications 1 à 5 caractérisé en ce que le film mince de silicium est un semi-conducteur en silicium d'une couche amorphe dans laquelle des particules microcristallines sont mélangées et dispersées.

8. Procédé suivant la revendication 1 ou l'une quelconque des revendications 2 à 7 caractérisé en ce qu'après réduction de la concentration de l'impureté et son remplacement corrélatif par le ou les éléments du plasma, un film mince de silicium du type (n) ou (p) est déposé sur le film mince de silicium.

9. Procédé suivant la revendication 1 ou l'une quelconque des revendications 2 à 7 caractérisé en ce qu'après réduction de la concentration de l'impureté et son remplacement corrélatif par le ou les éléments du plasma, un film mince de silicium du type (i) et un autre film mince de silicium du type (n) ou (p) du même matériau sont déposés sur le film soumis à l'action du plasma.

10. Procédé suivant la revendication 1 ou l'une quelconque des revendications 2 à 7 caractérisé en ce qu'on ajoute au gaz utilisé pour la décharge dans le plasma un gaz contenant un second élément d'impureté d'un type de conductivité opposé à celui de l'élément d'impureté se trouvant orginalement

## 0 069 580

dans le film si bien que, tandis que la concentration de l'élément d'impureté original va en diminuant, le film est simultanément dopé, jusqu'à une profondeur désirée, avec le second élément d'impureté.

11. Procédé suivant la revendication 10 caractérisé en ce que la profondeur jusqu'à laquelle la concentration de l'élément d'impureté original va en diminuant, et la profondeur du dopage avec le second élément d'impureté sont commandées en modifiant le rapport entre le gaz formé par le second élément d'impureté et le gaz sélectionné en le faisant varier dans une gamme allant de $10^{-5}$ à $10^{-1}$ et la densité de puissance électrique est commandée de manière à être comprise dans une gamme allant de 0,5 à 50 W/cm².

9

$$F\ I\ G.\quad 1$$

# F I G. 2

F I G. 3

# FIG. 4

# F I G. 5